# EUROPEAN PATENT APPLICATION

(11) **EP 4 350 786 A1**
(43) Date of publication of application: **10.04.2024**
(21) Application number: 23185626.1
(22) Date of filing: 14.07.2023
(51) Int. Cl.: H01L 33/00, H01L 33/02, H01L 33/06, H01L 33/20, H01L 33/30

(54) **LIGHT EMITTING ELEMENT AND METHOD OF FABRICATING LIGHT EMITTING ELEMENT**

(30) Priority: 05.10.2022 KR 20220127293
(71) Applicant: Samsung Display Co., Ltd., Yongin-si, Gyeonggi-do 17113 (KR)
(72) Inventor: LEE, Seung A, 17113 Yongin-si (KR); PARK, Bong Chun, 17113 Yongin-si (KR); LEE, Kwan Jae, 17113 Yongin-si (KR); LEE, Dong Eon, 17113 Yongin-si (KR); LEE, So Young, 17113 Yongin-si (KR)
(74) Representative: Marks & Clerk LLP

(57) **Abstract**

A light emitting element includes a first semiconductor layer, an active layer disposed on the first semiconductor layer, a second semiconductor layer disposed on the active layer, and an insulating layer enclosing the first semiconductor layer, the active layer, and at least a portion of the second semiconductor layer. The first semiconductor layer, the active layer, and the second semiconductor layer are successively disposed in a first direction. The active layer includes a first barrier layer, a second barrier layer, and a first well layer disposed between the first barrier layer and the second barrier layer, and including a non-uniform indium composition ratio in a first direction and a second direction intersecting the first direction, and including a non-uniform indium density in a third direction intersecting the first direction and the second direction.

## Description

### BACKGROUND

### 1. Technical Field

Various embodiments of the disclosure are directed to a light emitting element and a method of fabricating the light emitting element.

### 2. Description of Related Art

Recently, as interest in information display increases, research and development related to display devices has been continuously conducted.

### SUMMARY

Various embodiments of the disclosure relate to a light emitting element having enhanced reliability by preventing an increase of a luminance change rate of light emitted from the light emitting element.

Various embodiments of the disclosure are directed to a method of fabricating the light emitting element.

However, aspects of the disclosure are not limited to the above-described aspects, and various modifications are possible without departing from the scope of the disclosure.

An embodiment of the disclosure provides a light emitting element that includes a first semiconductor layer, an active layer disposed on the first semiconductor layer, a second semiconductor layer disposed on the active layer, and an insulating layer enclosing the first semiconductor layer, the active layer, and at least a portion of the second semiconductor layer. The first semiconductor layer, the active layer, and the second semiconductor layer are successively disposed in a first direction. The active layer includes a first barrier layer, a second barrier layer, and a first well layer disposed between the first barrier layer and the second barrier layer. The first well layer includes a non-uniform indium composition ratio in a first direction and a second direction intersecting the first direction, and includes a non-uniform indium density in a third direction intersecting the first direction and the second direction.

In an embodiment, the first well layer may include a first horizontal well area including a first indium composition ratio, and a second horizontal well area including a second indium composition ratio different from the first indium composition ratio. The first horizontal well area and the second horizontal well area may be successively disposed in the first direction.

In an embodiment, the first well layer may include, in the third direction, a first indium cluster including a first indium density, and a second indium cluster including a second indium density different from the first indium density.

In an embodiment, the first indium cluster and the second indium cluster may be formed in at least one area of the first horizontal well area and the second horizontal well area.

In an embodiment, the first well layer may further include a height compensation layer provided in an area including a relatively low indium composition ratio between the first horizontal well area and the second horizontal well area.

In an embodiment, a thickness of the first horizontal well area may be identical to a thickness of the second horizontal well area.

In an embodiment, an indium composition ratio of each of the first barrier layer and the second barrier layer may be lower than the first indium composition ratio and the second indium composition ratio.

In an embodiment, the first barrier layer may be disposed between the first semiconductor layer and the first horizontal well area, and the second barrier layer may be disposed between the second horizontal well area and the second semiconductor layer.

In an embodiment, a thickness of the first barrier layer may be identical to a thickness of the second barrier layer. The thickness of the first barrier layer may be greater than a thickness of each of the first horizontal well area and the second horizontal well area.

In an embodiment, the active layer may further include a third barrier layer and a second well layer. The second well layer may be disposed between the second barrier layer and the third barrier layer.

An embodiment of the disclosure provides a method of fabricating a light emitting element. The method includes forming a first semiconductor layer including a semiconductor of a first type on a substrate, forming an active layer on the first semiconductor layer, and forming a second semiconductor layer including a semiconductor of a second type different from the first type on the active layer. The forming of the active layer includes forming a first barrier layer, forming a first well layer including a non-uniform indium composition ratio in a first direction and a second direction intersecting the first direction, and including a non-uniform indium density in a third direction intersecting the first direction and the second direction, and forming a second barrier layer on the first well layer.

In an embodiment, the forming of the first well layer may include forming a first horizontal well area under first growth conditions such that the first horizontal well area has a first indium composition ratio in the first direction, and forming a second horizontal well area under second growth conditions such that the second horizontal well area has a second indium composition ratio in the first direction. The first growth conditions may be distinct from the second growth conditions in at least one of a growth temperature, an indium (In) injection rate, a gallium (Ga) injection rate, and a source gas injection rate.

In an embodiment, the forming of the first well layer may include including a temperature increase section ranging from a first temperature to a second temperature.

In an embodiment, the forming of the first horizontal well area may include forming the first horizontal area at the first temperature. The forming of the second horizontal well area may include forming the second horizontal well area on the first horizontal well area at a third temperature between the first temperature and the second temperature.

In an embodiment, the first barrier layer and the second barrier layer may be formed at a fourth temperature higher than the second temperature.

In an embodiment, the source gas may include hydrogen gas.

In an embodiment, the forming of the first well layer may further include forming a height compensation layer provided in an area including a relatively low indium composition ratio between the first horizontal well area and the second horizontal well area.

In an embodiment, a thickness of the first horizontal well area may be identical to a thickness of the second horizontal well area.

In an embodiment, in the third direction, a first indium cluster including a first indium density and a second indium cluster including a second indium density different from the first indium density may be formed in at least one area of the first horizontal well area and the second horizontal well area.

In an embodiment, the forming the first barrier layer and the second barrier layer may include a temperature maintenance section in which a temperature is maintained at the fourth temperature.

At least some of the above and other features of the invention are set out in the claims.

### BRIEF DESCRIPTION OF THE DRAWINGS

FIG. 1 is a schematic perspective view illustrating a light emitting element in accordance with embodiments of the disclosure.
FIG. 2 is a schematic sectional view illustrating an example of the light emitting element of FIG. 1.
FIG. 3 is a schematic plan view illustrating a display device in accordance with embodiments of the disclosure.
FIG. 4 is a schematic circuit diagram illustrating an example of the pixel included in the display device of FIG. 3.
FIGS. 5A and 5B are schematic sectional views illustrating an example of an active layer of the light emitting element of FIG. 1.
FIG. 6A is a schematic sectional view illustrating an example of a well layer which forms the active layer of FIG. 1.
FIG. 6B is a schematic plan view illustrating an example of a well layer which forms the active layer of FIG. 1.
FIG. 7 is a schematic sectional view illustrating another example of the well layer of FIG. 1.
FIG. 8 schematically illustrates composition of indium (In) according to temperature control during a process of fabricating the active layer of FIG. 1.
FIG. 9A schematically illustrates a comparative example of a current path formed in the well layer that forms the active layer.
FIG. 9B schematically illustrates a current path formed in the well layer that forms the active layer of FIG. 1.
FIG. 10 is a schematic flowchart illustrating a method of fabricating the light emitting element of FIG. 1.

### DETAILED DESCRIPTION OF THE EMBODIMENTS

Various embodiments of the disclosure will hereinafter be described in detail with reference to the accompanying drawings. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art. The same reference numerals are used throughout the different drawings to designate the same components, and repetitive description of the same components will be omitted.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean any combination including "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean any combination including "A, B, or A and B."

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the disclosure.

It will be understood that the terms "connected to" or "coupled to" may include a physical or electrical connection or coupling. When an element is referred to as being "in contact" or "contacting" or the like with another element, the element may be in "electrical contact" or in "physical contact" with another element.

The terms "comprises," "comprising," "includes," and/or "including," "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

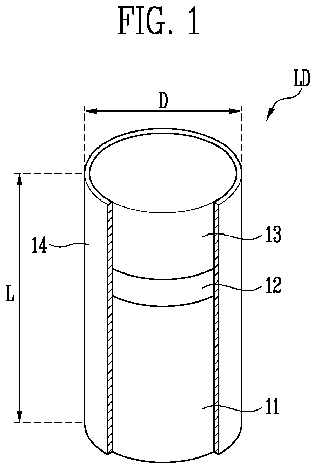

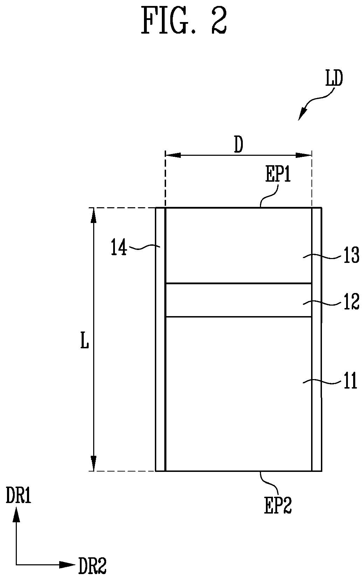

FIG. 1 is a schematic perspective view illustrating a light emitting element in accordance with embodiments of the disclosure. FIG. 2 is a schematic sectional view illustrating an example of the light emitting element of FIG. 1.

Referring to FIGS. 1 and 2, the light emitting element LD includes a first semiconductor layer 11, a second semiconductor layer 13, and an active layer 12 interposed between the first and second semiconductor layers 11 and 13. For example, the light emitting element LD may be implemented as an emission stack (or referred to as "stacked pattern") formed by successively stacking the first semiconductor layer 11, the active layer 12, and the second semiconductor layer 13.

In an embodiment, the light emitting element LD may have a shape extending in a direction. If the direction in which the light emitting element LD extends is defined as a longitudinal direction, the light emitting element LD may have a first end EP1 and a second end EP2 with respect to the longitudinal direction. One semiconductor layer of the first semiconductor layer 11 and the second semiconductor layer 13 may be disposed on the first end EP1 of the light emitting element LD, and the other semiconductor layer of the first semiconductor layer 11 and the second semiconductor layer 13 may be disposed on the second end EP2 of the light emitting element LD.

In an embodiment, the light emitting element LD may be provided in various shapes. For example, as illustrated in FIG. 1, the light emitting element LD may have a rod-like shape, a bar-like shape, or a pillar-like shape which is long (e.g., to have an aspect ratio greater than 1) with respect to the longitudinal direction (e.g., a first direction DR1). In another embodiment, the light emitting element LD may have a rod-like shape, a bar-like shape, or a pillar-like shape which is short with respect to the longitudinal direction (or has an aspect ratio less than 1). In yet another embodiment, the light emitting element LD may have a rod-like shape, a bar-like shape, or a pillar-like shape having an aspect ratio of 1.

The light emitting element LD may include a light emitting diode (LED) fabricated to have a subminiature size, e.g., with a diameter D and/or a length L corresponding to a range from the nano scale (or the nanometer scale) to the micro scale (or the micrometer scale).

In an embodiment, in the case in which the light emitting element LD is long (e.g., to have an aspect ratio greater than 1) with respect to the longitudinal direction, the diameter D of the light emitting element LD may range from about 0.5 µm to about 6 µm, and the length L thereof may range from about 1 µm to about 10 µm. However, the diameter D and the length L of the light emitting element LD are not limited thereto. The size of the light emitting element LD may be changed to meet requirements (or design conditions) of a lighting device or a self-emissive display device to which the light emitting element LD is applied.

In an embodiment, the first semiconductor layer 11 may include, for example, at least one n-type semiconductor layer. The first semiconductor layer 11 may include, with respect to the longitudinal direction of the light emitting element LD, an upper surface that contacts the active layer 12, and a lower surface exposed to the outside. The lower surface of the first semiconductor layer 11 may correspond to an end (or a lower end) of the light emitting element LD.

In an embodiment, the active layer 12 is disposed on the first semiconductor layer 11 and may have a single- or multi-quantum well structure. For example, in the case that the active layer 12 is formed to have a multi-quantum well structure, the active layer 12 may be formed by periodically repeatedly stacking a barrier layer, a strain reinforcing layer, and a well layer which are provided as one unit. The strain reinforcing layer may have a lattice constant less than that of the barrier layer so that resistance to strain, e.g., compressive strain, to be applied to the well layer can be further reinforced. However, the structure of the active layer 12 is not limited to that of the foregoing embodiment.

In an embodiment, the active layer 12 may emit light having a wavelength ranging from about 400 nm to about 900 nm, and have a double hetero structure. The active layer 12 may include a first surface which contacts the first semiconductor layer 11, and a second surface which contacts the second semiconductor layer 13.

In an embodiment, electrons injected into the first semiconductor layer 11 and holes injected into the second semiconductor layer 13 may be re-coupled to each other in a quantum well of the active layer 12, so that the active layer 12 may emit light corresponding to a band gap energy of the quantum well.

In an embodiment, a wavelength area of light emitted from the active layer 12 may be determined within a range from a long wavelength to a short wavelength depending on the content of indium (In) included in the active layer 12. In other words, as the content of indium (In) included in the active layer 12 is increased, the band gap may be reduced, and the wavelength area of light emitted from the active layer 12 may be close to the long wavelength. As the content of indium (In) included in the active layer 12 is reduced, the band gap is increased, and the wavelength area of light emitted from the active layer 12 may be close to the short wavelength.

In an embodiment, depending on the wavelength of light emitted from the active layer 12, the color (or output light color) of the light emitting element LD may be determined. The color of the light emitting element LD may determine the color of the corresponding pixel. For example, the light emitting element LD may emit red light, green light, or blue light.

In an embodiment, if an electric field having a certain voltage or more is applied between the opposite ends of the light emitting element LD, the light emitting element LD may emit light by coupling of electron-hole pairs in the active layer 12. Since light emission of the light emitting element LD can be controlled based on the foregoing principle, the light emitting element LD may be used as a light source (a light emitting source) of various light emitting devices as well as a pixel of a display device.

In an embodiment, the second semiconductor layer 13 may be disposed on the second surface of the active layer 12 and include a semiconductor layer of a type different from that of the first semiconductor layer 11. For example, the second semiconductor layer 13 may include at least one p-type semiconductor layer.

In an embodiment, the second semiconductor layer 13 may include, with regard to the longitudinal direction of the light emitting element LD, a lower surface that contacts the second surface of the active layer 12, and an upper surface exposed to the outside. Here, the upper surface of the second semiconductor layer 13 may correspond to a remaining end (or an upper end) of the light emitting element LD.

In an embodiment, the first semiconductor layer 11 and the second semiconductor layer 13 may have different thicknesses with respect to the longitudinal direction of the light emitting element LD. For example, the first semiconductor layer 11 may have a thickness greater than that of the second semiconductor layer 13 with respect to the longitudinal direction of the light emitting element LD. Hence, the active layer 12 of the light emitting element LD may be disposed at a position closer to the upper surface of the second semiconductor layer 13 than to the lower surface of the first semiconductor layer 11.

In an embodiment, although the first semiconductor layer 11 and the second semiconductor layer 13 each are formed of a single layer, the disclosure is not limited thereto. In an embodiment, depending on the material of the active layer 12, the first semiconductor layer 11 and the second semiconductor layer 13 each may further include one or more layers, for example, a clad layer and/or a tensile strain barrier reducing (TSBR) layer. The TSBR layer may be a strain relief layer which is disposed between semiconductor layers having different lattice structures and thus can function as a buffer layer to reduce a difference in lattice constant. Although the TSBR layer may be formed of a p-type semiconductor layer such as p-GaInP, p-AlInP, and/or p-AlGaInP, the disclosure is not limited thereto.

In an embodiment, the light emitting element LD may further include a contact electrode (hereinafter referred to as "first contact electrode") disposed over the second semiconductor layer 13, as well as including the first semiconductor layer 11, the active layer 12, and the second semiconductor layer 13. Furthermore, in an embodiment, the light emitting element LD may further include an additional contact electrode (hereinafter referred to as "second contact electrode") disposed on an end of the first semiconductor layer 11.

In an embodiment, each of the first and second contact electrodes may be an ohmic contact electrode, but the disclosure is not limited thereto. In an embodiment, each of the first and second contact electrodes may be a Schottky contact electrode. The first and second contact electrodes may include conductive material.

In an embodiment, the light emitting element LD may further include an insulating layer 14 (or referred to as "insulating film"). However, in some embodiments, the insulating layer 14 may be omitted, or may be provided to cover only some of the first semiconductor layer 11, the active layer 12, and the second semiconductor layer 13.

In an embodiment, the insulating layer 14 may prevent the active layer 12 from short-circuiting due to making contact with conductive material except the first and second semiconductor layers 11 and 13. Furthermore, the insulating layer 14 may minimize a surface defect of the light emitting element LD, thus enhancing the lifetime and emission efficiency of the light emitting element LD. The presence or non-presence of the insulating layer 14 is not limited, so long as the active layer 12 can be prevented from short-circuiting with external conductive material.

In an embodiment, the insulating layer 14 may be provided to enclose at least a portion of an outer circumferential surface of the emission stack including the first semiconductor layer 11, the active layer 12, and the second semiconductor layer 13.

Although in the foregoing embodiment the insulating layer 14 has been described as enclosing the entirety of the respective outer circumferential surfaces of the first semiconductor layer 11, the active layer 12, and the second semiconductor layer 13, the disclosure is not limited thereto.

In an embodiment, the insulating layer 14 may include transparent insulating material. For example, the insulating layer 14 may include at least of silicon oxide (SiOx), silicon nitride (SiNx), silicon oxynitride (SiOxNy), aluminium oxide (AlOx), titanium oxide (TiOx), hafnium oxide (HfOx), strontium titanium oxide (SrTiOx), cobalt oxide (CoxOy), magnesium oxide (MgO), zinc oxide (ZnOx), ruthenium oxide (RuOx), nickel oxide (NiO), tungsten oxide (WOx), tantalum oxide (TaOx), gadolinium oxide (GdOx), zirconium oxide (ZrOx), gallium oxide (GaOx), vanadium oxide (VxOy), ZnO:Al, ZnO:B, InxOy:H, niobium oxide (NbxOy), magnesium fluoride (MgFx), aluminium fluoride (AlFx), an alucone polymer film, titanium nitride (TiN), tantalum nitride (TaN), aluminium nitride (AINx), gallium nitride (GaN), tungsten nitride (WN), hafnium nitride (HfN), niobium nitride (NbN), gadolinium nitride (GdN), zirconium nitride (ZrN), and vanadium nitride (VN). However, the disclosure is not limited thereto, and various materials having insulation may be used as the material of the insulating layer 14.

In an embodiment, the insulating layer 14 may have a single-layer structure or a multi-layer structure including a double-layer structure.

The light emitting element LD may be employed as a light emitting source (or a light source) for various display devices. The light emitting element LD may be fabricated through a surface treatment process. For example, the light emitting element LD may be surface-treated so that, in the case multiple light emitting elements LD are mixed with a fluidic solution (or solvent) and supplied to each pixel area (e.g., an emission area of each pixel or an emission area of each sub-pixel), the light emitting elements LD can be evenly distributed rather than unevenly aggregating in the solution.

An emission component (or a light emitting device) including the light emitting element LD described above may be used not only in a display device but also in various types of electronic devices each of which requires a light source. For instance, in the case that multiple light emitting elements LD are disposed in the pixel area of each pixel of a display panel, the light emitting elements LD may be used as a light source of the pixel. However, the application field of the light emitting element LD is not limited to the above-mentioned examples. For example, the light emitting element LD may also be used in other types of electronic devices such as a lighting device, which requires a light source.

However, the foregoing is only for illustrative purposes, and the light emitting element LD in accordance with embodiments of the disclosure is not limited thereto. For example, the light emitting element may be a flip chip type micro light emitting diode, or an organic light emitting element including an organic emission layer.

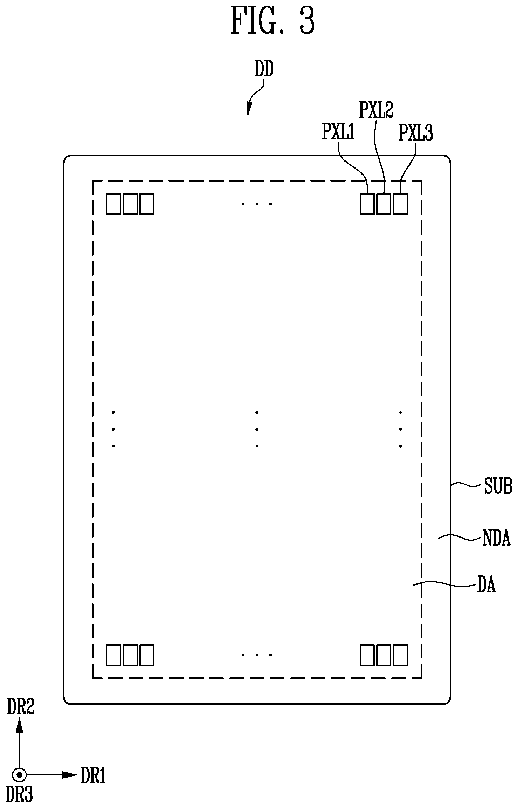

FIG. 3 is a schematic plan view illustrating a display device DD in accordance with embodiments of the disclosure.

Referring to FIGS. 1, 2, and 3, the display device DD may include a substrate SUB, pixels PXL1, PXL2, and PXL3 provided on the substrate SUB and each including at least one light emitting element LD, a driver provided on the substrate SUB and configured to drive the pixels PXL1, PXL2, and PXL3, and a line component provided to connect the pixels PXL1, PXL2, and PXL3 with the driver.

In an embodiment, the substrate SUB may include a display area DA and a non-display area NDA.

In an embodiment, the display area DA may be an area in which the pixels PXL1, PXL2, and PXL3 for displaying images are provided. The non-display area NDA may be an area in which the driver configured to drive the pixels PXL1, PXL2, and PXL3 and a portion of the line component for connecting the pixels PXL1, PXL2, and PXL3 to the driver are provided.

In an embodiment, the non-display area NDA may be disposed adjacent to the display area DA. The non-display area NDA may be provided on at least one side of the display area DA. For example, the non-display area NDA may enclose the perimeter (or edges) of the display area DA.

In an embodiment, the line component may electrically connect the driver with the pixels PXL1, PXL2, and PXL3. The line component may include a fanout line connected to signal lines, e.g., a scan line, a data line, and an emission control line, which are connected to each of the pixels PXL1, PXL2, and PXL3 to provide signals to each of the pixels PXL1, PXL2, and PXL3.

In an embodiment, the substrate SUB may include transparent insulating material to allow light transmission. The substrate SUB may be a rigid substrate or a flexible substrate.

In an embodiment, the pixels PXL1, PXL2, and PXL3 may include a first pixel PXL1, a second pixel PXL2, and a third pixel PXL3. In an embodiment, the first pixel PXL1 may be a red pixel, the second pixel PXL2 may be a green pixel, and the third pixel PXL3 may be a blue pixel. However, the disclosure is not limited to the foregoing. Each of the pixels PXL1, PXL2, and PXL3 may emit light having a color different from red, green, or blue.

In an embodiment, each of the pixels PXL1, PXL2, and PXL3 may include at least one or more light emitting elements LD configured to be driven in response to a corresponding scan signal and a corresponding data signal. The light emitting element LD may have a small size ranging from the nano scale (or the nanometer scale) to the micro scale (the mircrometer scale) and be connected in parallel to light emitting elements LD disposed adjacent thereto, but the disclosure is not limited thereto. The light emitting element LD may form a valid light source of each of the pixels PXL1, PXL2, and PXL3.

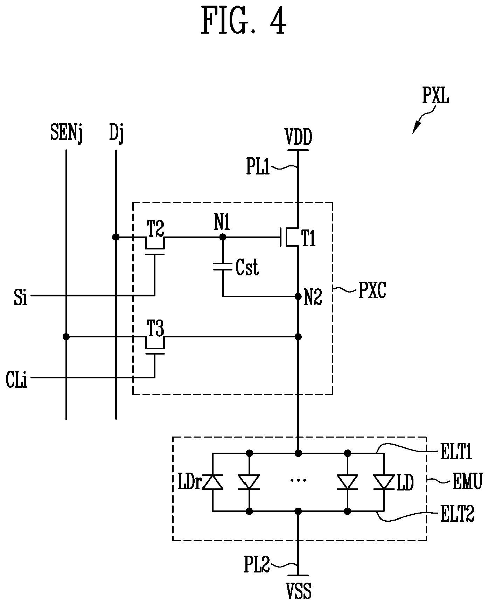

FIG. 4 is a schematic circuit diagram illustrating an example of the pixel included in the display device of FIG. 3.

In the following description, the term "pixel PXL" may be used to collectively designate the first pixel PXL1, the second pixel PXL2, and the third pixel PXL3.

Referring to FIGS. 1, 2, 3, and 4, the pixel PXL may include a pixel circuit PXC and an emission unit EMU (or an emission component).

Referring to FIGS. 1 to 4, the pixel PXL may include an emission unit EMU (or an emission layer) configured to generate light having a luminance corresponding to a data signal. Furthermore, the pixel PXL may selectively further include a pixel circuit PXC configured to drive the emission unit EMU.

In an embodiment, the emission unit EMU may include multiple light emitting elements LD connected in parallel between a first power line PL1 which is connected to a first driving power supply VDD and to which a voltage of the first driving power supply VDD is applied, and a second power line PL2 which is connected to a second driving power supply VSS and to which a voltage of the second driving power supply VSS is applied. For example, the emission unit EMU may include a first pixel electrode ELT1 connected to the first driving power supply VDD via the pixel circuit PXC and the first power line PL1, a second pixel electrode ELT2 connected to the second driving power supply VSS by the second power line PL2, and multiple light emitting elements LD connected in parallel to each other in the same direction between the first and second pixel electrodes ELT1 and ELT2. In an embodiment, the first pixel electrode ELT1 may be an anode, and the second pixel electrode ELT2 may be a cathode.

In an embodiment, each of the light emitting elements LD included in the emission unit EMU may include a first end connected to the first driving power supply VDD through the first pixel electrode ELT1, and a second end connected to the second driving power supply VSS through the second pixel electrode ELT2. The first driving power supply VDD and the second driving power supply VSS may have different potentials. For example, the first driving power supply VDD may be set as a high-potential power supply, and the second driving power supply VSS may be set as a low-potential power supply. Here, a difference in potential between the first and second driving power supplies VDD and VSS may be set to a value equal to or greater than a threshold voltage of the light emitting elements LD during an emission period of the pixel PXL.

As described above, the light emitting elements LD that are connected in parallel to each other in the same direction (e.g., in a forward direction) between the first pixel electrode ELT1 and the second pixel electrode ELT2 to which the voltages of the different power supplies are supplied may form respective valid light sources.

In an embodiment, the light emitting elements LD of the emission unit EMU may emit light having a luminance corresponding to driving current supplied thereto through the pixel circuit PXC. For example, during each frame period, the pixel circuit PXC may supply driving current corresponding to a grayscale value of corresponding frame data to the emission unit EMU. The driving current supplied to the emission unit EMU may be divided into parts which flow into the respective light emitting elements LD. Hence, each of the light emitting elements LD may emit light having a luminance corresponding to current applied thereto, so that the emission unit EMU may emit light having a luminance corresponding to the driving current.

Although there has been described an embodiment in which the opposite ends of the light emitting elements LD are connected in the same direction between the first and second driving power supplies VDD and VSS, the disclosure is not limited thereto. In an embodiment, the emission unit EMU may further include at least one invalid light source, e.g., a reverse light emitting element LDr, as well as including the light emitting elements LD that form the respective valid light sources. The reverse light emitting element LDr, along with the light emitting elements LD that form the valid light sources, may be connected in parallel between the first and second electrodes ELT1 and ELT2. Here, the reverse light emitting element LDr may be connected between the first and second electrodes ELT1 and ELT2 in a direction opposite to that of the light emitting elements LD. Even if a driving voltage (e.g., a normal directional driving voltage) is applied between the first and second pixel electrodes ELT1 and ELT2, the reverse light emitting element LDr may remain disabled. Hence, current substantially may not flow through the reverse light emitting element LDr.

The pixel circuit PXC may be connected to a scan line Si and a data line Dj of the pixel PXL. The pixel circuit PXC may be connected to a control line CLi and a sensing line SENj of the pixel PXL. For example, in the case in which the pixel PXL is disposed on an i-th row and a j-th column of the display area DA, the pixel circuit PXC of the pixel PXL may be connected to an i-th scan line Si, a j-th data line Dj, an i-th control line CLi, and a j-th sensing line SENj of the display area DA.

The pixel circuit PXC may include first to third transistors T1 to T3, and a storage capacitor Cst.

The first transistor T1 may be a driving transistor configured to control driving current to be applied to the emission unit EMU and be connected between the first driving power supply VDD and the emission unit EMU. In detail, a first terminal of the first transistor T1 may be connected (or coupled) to the first driving power supply VDD by the first power line PL1. A second terminal of the first transistor T1 may be connected to a second node N2. A gate electrode of the first transistor T1 may be connected to a first node N1. The first transistor T1 may control, in response to a voltage applied to the first node N1, the amount of driving current to be applied from the first driving power supply VDD to the emission unit EMU through the second node N2. In an embodiment, the first terminal of the first transistor T1 may be a drain electrode, and the second terminal of the first transistor T1 may be a source electrode, but the disclosure is not limited thereto. In an embodiment, the first terminal may be a source electrode, and the second terminal may be a drain electrode.

The second transistor T2 may be a switching transistor which selects a pixel PXL in response to a scan signal and activates the pixel PXL, and may be connected between the data line Dj and the first node N1. A first terminal of the second transistor T2 may be connected to the data line Dj. A second terminal of the second transistor T2 may be connected to the first node N1. A gate electrode of the second transistor T2 may be connected to the scan line Si. The first terminal and the second terminal of the second transistor T2 may be different terminals, and, for example, if the first terminal is a drain electrode, the second terminal may be a source electrode.

In the case that a scan signal having a gate-on voltage (e.g., a high level voltage) is supplied from the scan line Si, the second transistor T2 may be turned on to electrically connect the data line Dj with the first node N1. The first node N1 may be a point at which the second terminal of the second transistor T2 and the gate electrode of the first transistor T1 are connected to each other. The second transistor T2 may transmit a data signal to the gate electrode of the first transistor T1.

The third transistor T3 may obtain a sensing signal through the sensing line SENj by connecting the first transistor T1 to the sensing line SENj, and detect, using the sensing signal, characteristics of the pixel PXL such as a threshold voltage of the first transistor T1. Information about the characteristics of the pixel PXL may be used to convert image data such that a deviation in characteristic between pixels PXL can be compensated for. A second terminal of the third transistor T3 may be connected to the second terminal of the first transistor T1. A first terminal of the third transistor T3 may be connected to the sensing line SENj. A gate electrode of the third transistor T3 may be connected to the control line CLi. Furthermore, the first terminal of the third transistor T3 may be connected to an initialization power supply. The third transistor T3 may be an initialization transistor configured to initialize the second node N2, and may be turned on in the case that a sensing control signal is supplied thereto from the control line CLi, so that the voltage of the initialization power supply can be transmitted to the second node N2. Hence, a second storage electrode of the storage capacitor Cst connected to the second node N2 may be initialized.

A first storage electrode of the storage capacitor Cst may be connected to the first node N1. A second storage electrode of the storage capacitor Cst may be connected to the second node N2. The storage capacitor Cst may be charged with a data voltage corresponding to a data signal to be supplied to the first node N1 during a frame period. Hence, the storage capacitor Cst may store a voltage corresponding to a difference between a voltage of the gate electrode of the first transistor T1 and a voltage of the second node N2.

Although FIG. 4 illustrates an embodiment in which all of the light emitting elements LD that form the emission unit EMU are connected in parallel to each other, the disclosure is not limited thereto. In an embodiment, the emission unit EMU may include at least one serial set (or stage) including multiple light emitting elements LD connected in parallel to each other. In other words, the emission unit EMU may be formed of a series/parallel combination structure.

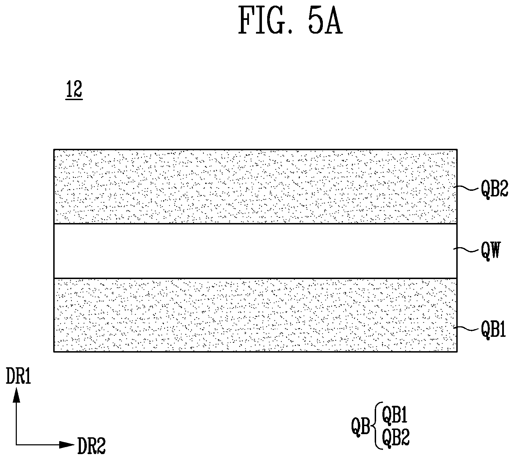

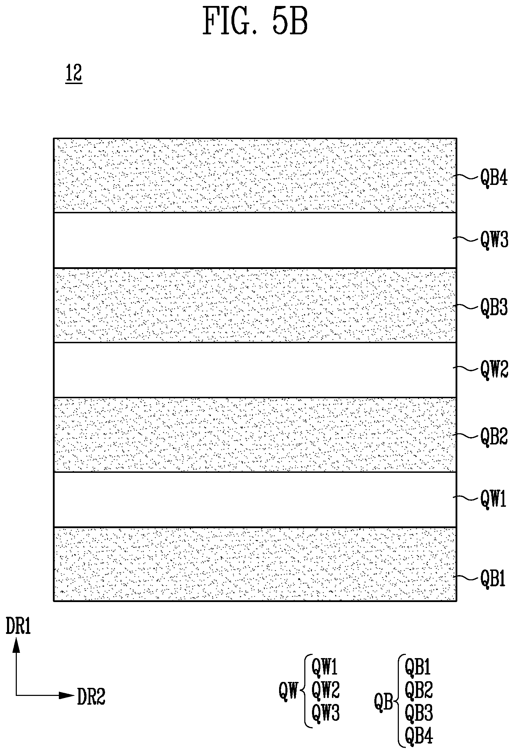

FIGS. 5A and 5B are schematic sectional views illustrating an example of an active layer of the light emitting element of FIG. 1.

Referring to FIG. 5A, the active layer 12 may have a single-quantum well structure including barrier layers QB and a well layer QW disposed between the barrier layers QB. Referring to FIG. 5B, the active layer 12 may have a multi-quantum well structure in which barrier layers QB and well layers QW alternate multiple times and are successively stacked on each other.

Referring to FIGS. 1 and 5A, the barrier layers QB may include a first barrier layer QB1 and a second barrier layer QB2. The first barrier layer QB1 may be disposed between the first semiconductor layer 11 and the well layer QW. The second barrier layer QB2 may be disposed between the well layer QW and the second semiconductor layer 13.

Referring to FIGS. 1 and 5B, the barrier layers QB may include first to fourth barrier layers QB1 to QB4, and the well layers QW may include first to third well layers QW1 to QW3. In an embodiment, the active layer 12 may have a multilayer structure in which the first to fourth barrier layers QB1 to QB4 and the first to third well layers QW1 to QW3 are alternately successively stacked on each other.

In an embodiment, the first barrier layer QB1 and the second barrier layer QB2 may be formed on the first semiconductor layer 11 with the first well layer QW1 interposed therebetween. In an embodiment, the second barrier layer QB2 and the third barrier layer QB3 may be formed on the first well layer QW1 with the second well layer QW2 interposed therebetween. In an embodiment, the third barrier layer QB3 and the fourth barrier layer QB4 may be formed on the second well layer QW2 with the third well layer QW3 interposed therebetween.

In an embodiment, the first to fourth barrier layers QB1 to QB4 may have the same thickness in the first direction DR1. In an embodiment, the first to fourth barrier layers QB1 to QB4 may have different thicknesses in the first direction DR1. For example, the first barrier layer QB1 may be thinner or thicker than the second barrier layer QB2 in the first direction DR1.

Hereinafter, the term "well layer QW" will be used to collectively designate the first, second, and third well layers QW1, QW2, and QW3, and the term "barrier layer QB" will be used to collectively designate the first, second, third, and fourth barrier layers QB1, QB2, QB3, and QB4.

In an embodiment, the thickness of the barrier layer QB in the first direction DR1 may be greater than that of the well layer QW.

In an embodiment, the well layer QW may include at least one of InGaN, InAlGaN, and InGaP. The barrier layer QB may include at least one of GaN, InGaN, AlGaP, and AlGaAs.

Referring to FIGS. 5A and 5B, the active layer 12 includes barrier layers QB, and a well layer QW disposed between the barrier layers QB. In an embodiment, the barrier layer QB and the well layer QW may have different compositions. For example, the well layer QW may have an indium (In) composition ratio higher than that of the barrier layer QB.

In an embodiment, the well layer QW may have a non-uniform indium density in the first direction DR1 and a second direction DR2.

Referring to FIG. 5A, a first area of the well layer QW that is adjacent to the first barrier layer QB1 in the active layer 12 may have an indium composition ratio higher than that of a second area of the well layer QW that is adjacent to the second barrier layer QB2. In an embodiment, the second area of the well layer QW that is adjacent to the second barrier layer QB2 may have an indium composition ratio higher than that of the first area of the well layer QW that is adjacent to the first barrier layer QB1. In an embodiment, an indium density in the first area of the well layer QW that is adjacent to the first barrier layer QB1 may also be non-uniform in the second direction DR2.

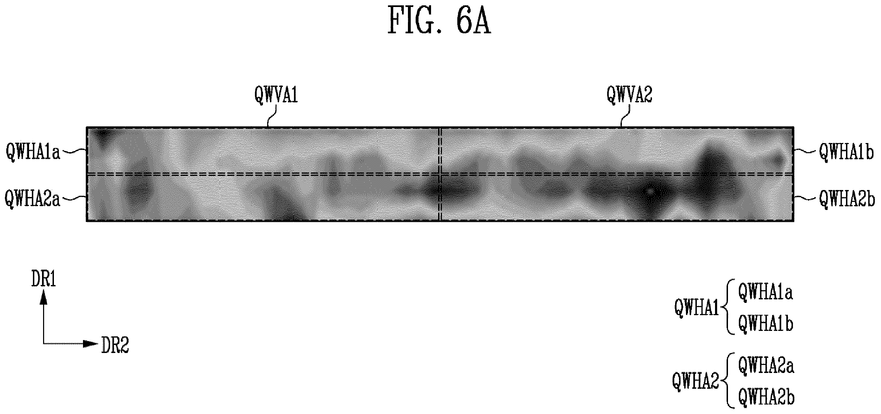

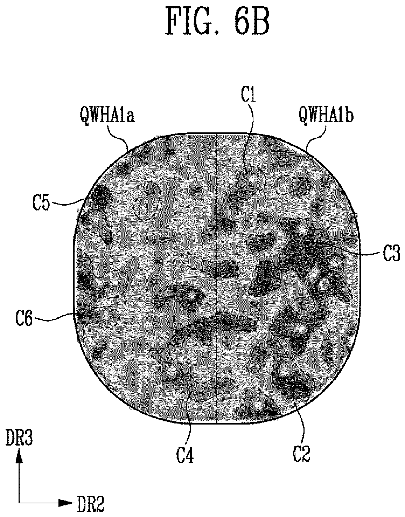

Referring to FIG. 5B, a first area of the first well layer QW1 that is adjacent to the first barrier layer QB1 may have an indium composition ratio higher than that of a second area of the first well layer QW1 that is adjacent to the second barrier layer QB2. Technical characteristics applied to the first well layer QW1 may also be identically or similarly applied to the second to fourth well layers QW2 to QW4. FIG. 6A is a schematic sectional view illustrating an example of a well layer which forms the active layer of FIG. 1. FIG. 6B is a schematic plan view illustrating an example of a well layer which forms the active layer of FIG. 1.

Referring to FIGS. 6A and 6B, the well layer QW may refer to at least one well layer among the well layer QW of FIG. 5A having a single-quantum well structure of FIG. 5A and the first, second, and third well layers QW1, QW2, and QW3 of FIG. 5B each having a multi-quantum well structure.

In an embodiment, the active layer 12 of FIG. 1 may be an area in which light is emitted by re-coupling of electrons and holes that are moved to the well layer QW. In an embodiment, the well layer QW may be formed of InGaN, but the disclosure is not limited thereto. For example, the well layer QW may be formed of AlGaInP and/or GaInP. The wavelength of light emitted from the active layer (e.g., the active layer 12 of FIG. 1) may depend on an indium ratio of the well layer QW. For example, to emit light of a long wavelength band, the well layer QW may be doped with indium at a relatively high indium ratio. To emit light of a short wavelength band, the well layer QW may be doped with indium at a relatively low indium ratio. In other words, the composition ratio of indium with which the well layer QW is doped may be controlled depending on the wavelength band of light emitted from the active layer 12.

Referring to FIG. 6A, the well layer QW may include a first vertical well area QWVA1 having a first indium composition ratio, and a second vertical well area QWVA2 having a second indium composition ratio distinct from the first indium composition ratio. In an embodiment, the first vertical well area QWVA1 and the second vertical well area QWVA2 may be arranged in the second direction DR2.

In an embodiment, the first indium composition ratio may be lower than the second indium composition ratio. In other words, during a growth process of the well layer QW, the first vertical well area QWVA1 may be doped with indium at a relatively low composition ratio compared to that of the second vertical well area QWVA2.

Referring to FIG. 6A, the well layer QW may include a first horizontal well area QWHA1 having a third indium composition ratio, and a second horizontal well area QWHA2 having a fourth indium composition ratio distinct from the third indium composition ratio. In an embodiment, the first horizontal well area QWHA1 may include a 1_1-th horizontal well area QWHA1a included in the first vertical well area QWVA1, and a 1_2-th horizontal well area QWHA1b included in the second vertical well area QWVA2. In an embodiment, the second horizontal well area QWHA2 may include a 2_1-th horizontal well area QWHA2a included in the first vertical well area QWVA1, and a 2_2-th horizontal well area QWHA2b included in the second vertical well area QWVA2. In an embodiment, the third indium composition ratio may be lower than the fourth indium composition ratio. For example, the first horizontal well area QWHA1 may not be doped with indium or may be doped with a small amount of indium. The disclosure is not limited thereto. The third indium composition ratio may be identical to or higher than the fourth indium composition ratio.

In an embodiment, the first horizontal well area QWHA1 and the second horizontal well area QWHA2 may be arranged in the first direction DR1. In an embodiment, the barrier layer QB may be disposed on an upper surface of the first horizontal well area QWHA1 (e.g., in the first direction DR1). The barrier layer QB may be disposed on a lower surface of the second horizontal well area QWHA2 (e.g., in a direction opposite to the first direction DR1).

In an embodiment, the third indium composition ratio may be lower than the fourth indium composition ratio. In other words, during a growth process of the well layer QW, the first horizontal well area QWHA1 may be doped with indium at a relatively low composition ratio compared to that of the second horizontal well area QWHA2.

In an embodiment, indium may be non-uniformly distributed in the well layer QW in the first direction DR1 and the second direction DR2.

FIG. 6B is a sectional view showing the first horizontal well area QWHA1 of the well layer QW.

In an embodiment, the first horizontal well area QWHA1 may include non-uniform indium clusters (or aggregation). In an embodiment, each of the 1_1-th horizontal well area QWHA1a and the 1_2-th horizontal well area QWHA1b may include indium clusters C1, C2, C3, C4, C5, and C6 having non-uniform sizes. In an embodiment, each of the indium clusters C1, C2, C3, C4, C5, and C6 may have different indium densities and/or different sizes. For example, the first cluster C1 may have a size less than the second cluster C2. The first cluster C1 may have a first indium density. The second cluster C2 may have a second indium density. The first indium density may be lower than the second indium density.

In an embodiment, the indium clusters included in the first horizontal well area QWHA1 may be formed by a difference in energy band gap between a high indium composition area and an a non-indium or extremely low indium composition area. In an embodiment, the 1_2-th horizontal well area QWHA1b may have an indium composition ratio higher than that of the 1_1-th horizontal well area QWHA1a, and the sizes of clusters formed in the 1_2 horizontal well area QWHA1b may be relatively large due to self-assembly characteristics of indium.

In an embodiment, the well layer QW may be formed by a metal organic chemical vapor deposition (MOCVD) method.

In an embodiment, during growth of the well layer QW of the active layer 12, growth conditions of the well layer QW may be controlled to secure non-uniformity of indium that is a component of the well layer QW. The foregoing growth conditions may include conditions for controlling at least one of an indium (In) injection rate, a gallium (Ga) injection rate, a growth temperature, and/or a source gas inflow rate.

In an embodiment, during a process in which the first horizontal well area QWHA1 and the second horizontal well area QWHA2 grow in the first direction DR1, the amount of indium injected into the second vertical well area QWVA2 may be greater than that of the first vertical well area QWVA1. The second vertical well area QWVA2 may have an indium composition ratio higher than that of the first vertical well area QWVA1. In an embodiment, the amount of indium injected into the second horizontal well area QWHA2 may be greater than that of the first horizontal well area QWHA1. The second horizontal well area QWHA2 may have an indium composition ratio higher than that of the first horizontal well area QWHA1.

In an embodiment, during the process in which the first horizontal well area QWHA1 and the second horizontal well area QWHA2 grow in the first direction DR1, the amount of gallium injected into the second vertical well area QWVA2 may be greater than that of the first vertical well area QWVA1. Here, as the amount of gallium injected along with indium is increased, the effect of preventing the indium from being volatilized may be increased. Hence, the second vertical well area QWVA2 may have an indium composition ratio higher than that of the first vertical well area QWVA1. In an embodiment, the amount of gallium injected into the first horizontal well area QWHA1 may be greater than that of the second horizontal well area QWHA2. The second horizontal well area QWHA2 may have an indium composition ratio higher than that of the first horizontal well area QWHA1.

In an embodiment, during a process in which the first horizontal well area QWHA1 and the second horizontal well area QWHA2 grow in the first direction DR1, the first horizontal well area QWHA1 may be formed at a first growth temperature, and the second horizontal well area QWHA2 may be formed at a second growth temperature lower than the first growth temperature. As the growth temperature is reduced, the amount with which indium is volatilized may be relatively reduced. Hence, the second horizontal well area QWHA2 may have an indium composition ratio higher than that of the first horizontal well area QWHA1.

In an embodiment, during the process in which the first horizontal well area QWHA1 and the second horizontal well area QWHA2 grow in the first direction DR1, the amount of source gas injected into the first horizontal well area QWHA1 may be greater than that of the second horizontal well area QWHA2. Because the source gas accelerates volatilization of indium, the second horizontal well area QWHA2 may have an indium composition ratio higher than that of the first horizontal well area QWHA1. In an embodiment, the source gas may include at least one of oxygen (H₂) and nitrogen (N₂).

Referring to FIG. 6A and 6B, the well layer QW may be formed to have a non-uniform indium density in the first to third directions DR1, DR2, and DR3. The well layer QW is formed to have a non-uniform indium composition ratio in the first direction DR1 and the second direction DR2. Clusters C1, C2, C3, C4, C5, and C6 formed in the third direction DR3 (e.g., an in-plane direction) due to the non-uniform indium composition ratio may restrain (or prevent) a current path from being formed toward the edge of the well layer QW. For example, because the formation of the current path in the well layer QW is restrained, electrons injected into the well layer QW may be prevented from moving along the current path and moving along the edge of the well layer QW. The disclosure may mitigate a phenomenon in which the reliability of light emitted from the active layer 12 is reduced by a luminance change rate of light emitted from the active layer 12 due to movement of electrons along the edge of the well layer QW.

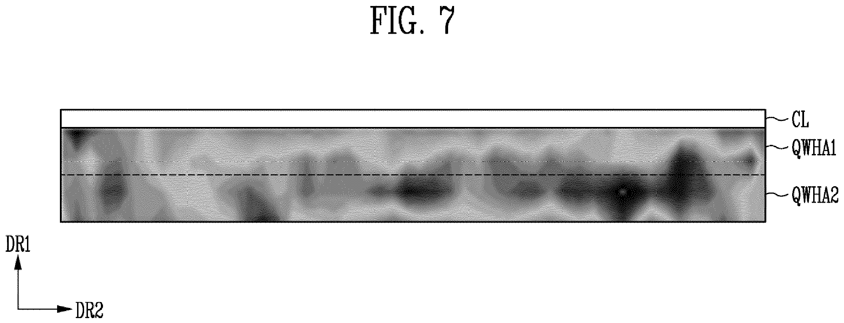

FIG. 7 is a schematic sectional view illustrating another example of the well layer of FIG. 1.

In an embodiment, a height of the well layer QW in the first direction DR1 may be less than a height of a well layer formed to have a uniform indium composition ratio. Therefore, to compensate for a height deviation due to a non-uniform indium composition ratio, the well layer QW may include a height compensation layer CL. In an embodiment, the height compensation layer CL may be disposed in a region of a well horizontal area having a relatively low indium composition ratio in the well layer QW.

In an embodiment, in the case where, of the first horizontal well area QWHA1 and the second horizontal well area QWHA2, the indium composition ratio of the first horizontal well area QWHA1 is less than that of the second horizontal well area QWHA2, a thickness of the first horizontal well area QWHA1 in the first direction DR1 may be less than that of the second horizontal well area QWHA2, but the disclosure is not limited thereto. The thickness of the first horizontal well area QWHA1 in the first direction DR1 may be the same as that of the second horizontal well area QWHA2.

In an embodiment, in the case where, of the first horizontal well area QWHA1 and the second horizontal well area QWHA2, the indium composition ratio of the first horizontal well area QWHA1 is less than that of the second horizontal well area QWHA2, the height compensation layer CL may be disposed on a surface of the first horizontal well area QWHA1, but the disclosure is not limited thereto. For example, in the case where, of the first horizontal well area QWHA1 and the second horizontal well area QWHA2, the indium composition ratio of the first horizontal well area QWHA1 is less than that of the second horizontal well area QWHA2, the height compensation layer CL may be disposed on a surface of the second horizontal well area QWHA2. In an embodiment, the thickness of each of the first horizontal well area QWHA1 and the second horizontal well area QWHA2 in the first direction DR1 may be about 1.6 nm, but the disclosure is not limited thereto. The thickness of each of the first horizontal well area QWHA1 and the second horizontal well area QWHA2 in the first direction DR1 may be about 1.6 nm or more.

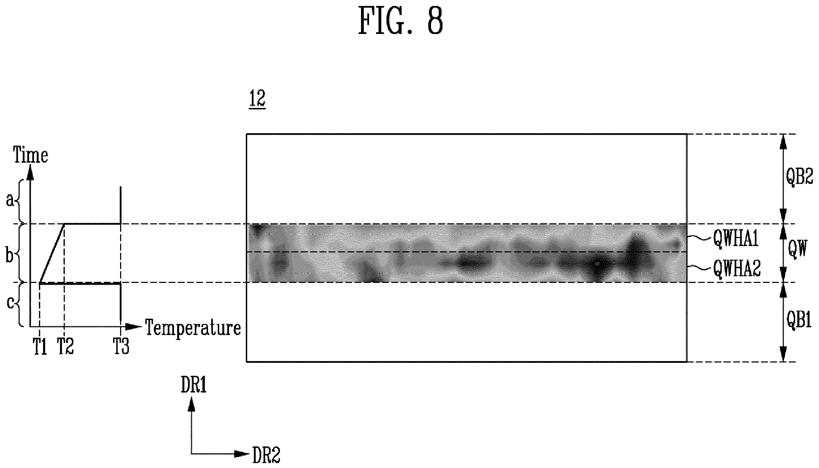

FIG. 8 schematically illustrates composition of indium (In) according to temperature control during a process of fabricating the active layer of FIG. 1.

In an embodiment, after a first semiconductor layer (e.g., the first semiconductor layer 11) is formed, the active layer 12 is formed on the first semiconductor layer 11.

Referring to FIG. 8, a growth process of the active layer 12 may be performed in such a way that a section in which barrier layers QB grow and a section in which a well layer QW grows intersect with each other.

In an embodiment, the barrier layers QB and the well layer QW may be respectively formed at different temperatures. A third section c may be a section in which a first barrier layer QB1 to be formed in contact with the first semiconductor layer 11 among the barrier layers QB grows. A second section b may be a section in which the well layer QW to be formed in contact with the first barrier layer QB1 grows. A first section a may be a section in which a second barrier layer QB2 to be formed in contact with the well layer QW grows.

In an embodiment, the first and second barrier layers QB1 and QB2 may grow in a section in which a third temperature T3 is maintained. The well layer QW may grow in a section between a first temperature T1 and a second temperature T2, which are lower than the third temperature T3. The first temperature T1 may be lower than the second temperature T2.

In an embodiment, each of the first section a and the third section c in which the barrier layers QB grow may include a temperature maintenance section. The second section b in which the well layer QW grows may include a temperature increase section ranging from the first temperature T1 to the second temperature T2. The temperature increase section (or a temperature reduction section) may be formed in only the second section b in which the well layer QW grows.

In an embodiment, after the first barrier layer QB1 is formed at the third temperature T3, the growth temperature may be reduced from the third temperature T3 to the first temperature T1. Because the growth temperature of the well layer QW gradually increases from the first temperature T1 to the second temperature T2, the well layer QW may grow on the first barrier layer QB1.

In an embodiment, as the growth temperature increases from the first temperature T1 to the second temperature T2 in the second section b in which the well layer QW grows, the indium composition ratio may be non-uniformly formed in the well layer QW.

In an embodiment, in the second section b, the second horizontal well area QWHA2 having the fourth indium composition ratio may be formed by gradually increasing the growth temperature from the first temperature T1 to a temperature between the first temperature T1 and the second temperature T2. In the second section b, the first horizontal well area QWHA1 having a third indium composition ratio lower than the fourth indium composition ratio may be formed by gradually growing the growth temperature from the temperature between the first temperature T1 and the second temperature T2 to the second temperature T2.

In an embodiment, the growth temperature after the well layer QW is formed may increase from the second temperature T2 to the third temperature T3. The second barrier layer QB2 may grow on the well layer QW at the third temperature T3.

In an embodiment, the indium composition ratio of each of the first and second barrier layers QB1 and QB2 may be lower than the indium composition ratio of the well layer QW.

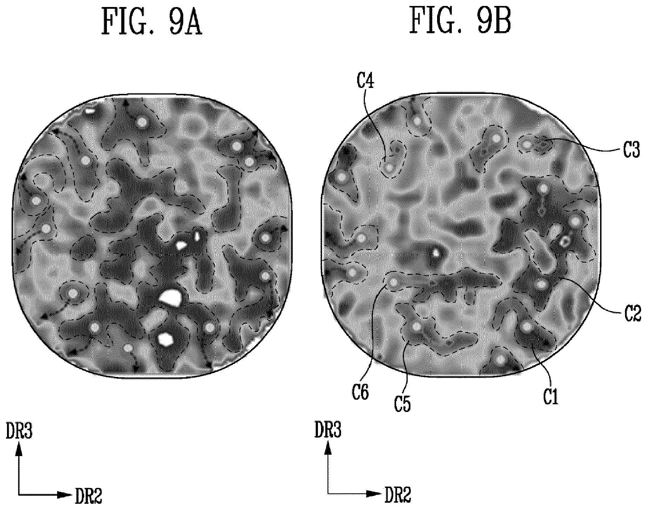

FIG. 9A schematically illustrates a comparative example of a current path formed in the well layer that forms the active layer.

FIG. 9B schematically illustrates a current path formed in the well layer that forms the active layer of FIG. 1.

FIG. 9A refers to the comparative example, and illustrates a current path which is formed along the edge of the well layer in the case where indium is uniformly formed in the well layer. In other words, because indium that forms the well layer is uniformly formed, a current path toward the edge of the well layer may be readily formed, so that the amount of electrons that move through the current path may be increased. As a result, the luminance change rate of light emitted from the active layer 12 is increased, so that the reliability may be reduced.

FIG. 9B illustrates a well layer QW in which indium is non-uniformly formed according to the disclosure. The well layer QW may be formed to have a non-uniform indium composition ratio. Clusters C1, C2, C3, C4, C5, and C6 formed in the third direction DR3 (e.g., an in-plane direction) may restrain (or prevent) a current path from being formed toward the edge of the well layer QW. In other words, the clusters C1, C2, C3, C4, C5, and C6 make it difficult for a current path to be formed along the edge of the well layer QW. For example, because the formation of current paths in the well layer QW is restrained, electrons injected into the well layer QW may be prevented from moving along the current path and moving along the edge of the well layer QW. The disclosure may mitigate a phenomenon in which the reliability is reduced by an increase in a luminance change rate of light emitted from the active layer 12 due to movement of electrons along the edge of the well layer QW. Consequently, the reliability of light outputted from the active layer 12 may be enhanced.

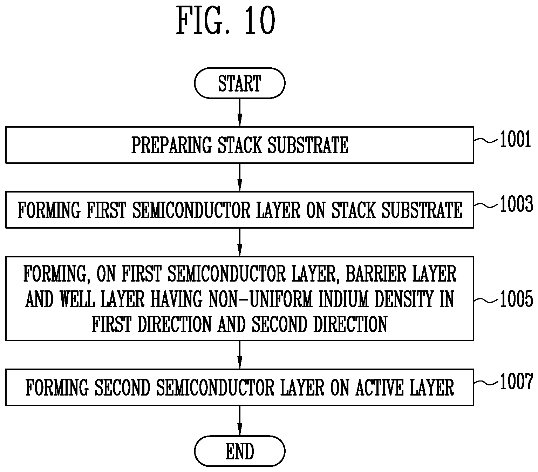

FIG. 10 is a schematic flowchart illustrating a method of fabricating the light emitting element of FIG. 1.

In an embodiment, a stacked substrate may be prepared, at step 1001. The stack substrate may be a base plate provided to stack target materials. For example, the stack substrate may be a wafer for epitaxial growth of a desired material. In an embodiment, the stack substrate may be at least one of a sapphire substrate, a GaAs substrate, a Ga substrate, an InP substrate, but the disclosure is not limited thereto.

In an embodiment, a first semiconductor layer (e.g., the first semiconductor layer 11 of FIG. 1), an active layer (e.g., the active layer 12 of FIG. 1), and a second semiconductor layer (e.g., the second semiconductor layer 13 of FIG. 1) are successively stacked on the stack structure. The first semiconductor layer 11, the active layer 12, and the second semiconductor layer 13 each may be formed by at least one method of a metal organic chemical vapor-phase deposition (MOCVD) method, a molecular beam epitaxy (MBE) method, a vapor phase epitaxy (VPE) method, and a liquid phase epitaxy (LPE) method.

In an embodiment, at step 1003, the first semiconductor layer 11 may be formed on the stack substrate.

In an embodiment, at step 1005, the active layer 12 is formed on the first semiconductor layer 11. In an embodiment, a barrier layer (e.g., the barrier layer QB of FIGS. 5A and 5B) and a well layer (e.g., the well layer QW of FIGS. 5A and 5B) are alternately disposed on the first semiconductor layer 11.

In an embodiment, after the first barrier layer QB1 is formed on the first semiconductor layer 11, the well layer QW may be formed on the first barrier layer QB1 to have a non-uniform indium composition ratio in the first direction and have a non-uniform indium density in the third direction intersecting the first direction.

In an embodiment, during a process of forming the well layer QW, growth conditions of the well layer QW may be changed to increase non-uniformity of indium in the well layer QW. In an embodiment, at least one of an indium (In) injection rate, a gallium (Ga) injection rate, a growth temperature, and/or a source gas inflow rate may be controlled during the process of forming the well layer QW. In an embodiment, the well layer QW may include well areas having different indium composition ratios in a first direction (e.g., the first direction DR1 of FIG. 6A) and/or a second direction (e.g., the second direction DR2 of FIG. 6A). In an embodiment, in the well layer QW, indium clusters (e.g., the clusters C1, C2, C3, C4, C5, and C6 of FIG. 6B) having different sizes and/or densities in a third direction (e.g., the third direction DR3 of FIG. 6B) intersecting the first direction and the second direction may be formed.

In an embodiment, after the well layer QW is formed, the second barrier layer QB2 is formed on the well layer QW.

In an embodiment, the barrier layer QB may be an undoped semiconductor layer to prevent a defect from occurring in the well layer QW. In an embodiment, the barrier layer QB may include at least one semiconductor material of InAlGaN, GaN, AlGaN, InGaN, AlN, and InN, and a separate dopant may not be provided to the barrier layer QB.

In an embodiment, an indium composition ratio in the barrier layer QB may be less than an indium composition ratio in the well layer QW.

In an embodiment, at step 1007, the second semiconductor layer 13 is formed on the active layer 12. In an embodiment, the second semiconductor layer 13 may be formed on the second barrier layer QB2.

In a light emitting element and a method of fabricating the light emitting element in accordance with embodiments of the disclosure, a well layer that forms an active layer is formed to have a non-uniform indium density, so that a current path can be restrained (or prevented) from being formed toward an edge of the well layer QW. For example, because the formation of current paths in the well layer QW is restrained, electrons injected into the well layer QW may be prevented from moving along the current path and moving along the edge of the well layer QW. The disclosure may mitigate a phenomenon in which the reliability of light emitted from the active layer 12 is reduced by a luminance change rate of light emitted from the active layer 12 due to movement of electrons along the edge of the well layer QW.

In a light emitting element and a method of fabricating the light emitting element in accordance with embodiments of the disclosure, a well layer that forms an active layer of the light emitting element is formed to have a non-uniform indium density, so that a current path can be restrained (or prevented) from being formed toward an edge of the well layer. In other words, because the formation of the current path in the well layer is restrained, electrons injected into the well layer may be prevented from moving along the current path and moving along the edge of the well layer.

The disclosure may mitigate a phenomenon in which the reliability of light emitted from the active layer is reduced by a luminance change rate of light emitted from the active layer due to movement of electrons along the edge of the well layer. However, effects of the disclosure are not limited to the above-described effects, and various modifications are possible without departing from the scope of the disclosure.

While embodiments of the disclosure have been described above, those skilled in the art will appreciate that various modifications, additions and substitutions are possible, without departing from the scope of the disclosure.

## Claims

1. A light emitting element comprising:
a first semiconductor layer;
an active layer disposed on the first semiconductor layer;
a second semiconductor layer disposed on the active layer; and
an insulating layer enclosing the first semiconductor layer, the active layer, and at least a portion of the second semiconductor layer, wherein
the first semiconductor layer, the active layer, and the second semiconductor layer are successively disposed in a first direction,
the active layer comprises:
a first barrier layer;
a second barrier layer; and
a first well layer disposed between the first barrier layer and the second barrier layer, and including a non-uniform indium composition ratio in a first direction and a second direction intersecting the first direction, and including a non-uniform indium density in a third direction intersecting the first direction and the second direction.

2. The light emitting element according to claim 1, wherein
the first well layer comprises:
a first horizontal well area including a first indium composition ratio;
and
a second horizontal well area including a second indium composition ratio different from the first indium composition ratio, and
the first horizontal well area and the second horizontal well area are successively disposed in the first direction.

3. The light emitting element according to claim 2, wherein the first well layer includes, in the third direction:
a first indium cluster including a first indium density; and
a second indium cluster including a second indium density different from the first indium density, and
wherein the first indium cluster and the second indium cluster are formed in at least one area of the first horizontal well area and the second horizontal well area.

4. The light emitting element according to claim 2 or claim 3, wherein the first well layer further includes a height compensation layer provided in an area including a relatively low indium composition ratio between the first horizontal well area and the second horizontal well area.

5. The light emitting element according to claim 4, wherein a thickness of the first horizontal well area is identical to a thickness of the second horizontal well area.

6. The light emitting element according to any one of claims 2 to 5, wherein an indium composition ratio of each of the first barrier layer and the second barrier layer is lower than the first indium composition ratio and the second indium composition ratio.

7. The light emitting element according to any one of claims 2 to 6,
wherein
the first barrier layer is disposed between the first semiconductor layer and the first horizontal well area, and
the second barrier layer is disposed between the second horizontal well area and the second semiconductor layer,
a thickness of the first barrier layer is identical to a thickness of the second barrier layer, and
the thickness of the first barrier layer is greater than a thickness of each of the first horizontal well area and the second horizontal well area.

8. The light emitting element according to claim 2, wherein
the active layer further comprises a third barrier layer and a second well layer, and
the second well layer is disposed between the second barrier layer and the third barrier layer.

9. A method of fabricating a light emitting element, comprising:
forming a first semiconductor layer including a semiconductor of a first type on a substrate;
forming an active layer on the first semiconductor layer; and
forming a second semiconductor layer including a semiconductor of a second type different from the first type on the active layer,
wherein the forming of the active layer comprises:
forming a first barrier layer;
forming a first well layer including a non-uniform indium composition ratio in a first direction and a second direction intersecting the first direction, and including a non-uniform indium density in a third direction intersecting the first direction and the second direction; and
forming a second barrier layer on the first well layer.

10. The method according to claim 9, wherein
the forming of the first well layer comprises:
forming a first horizontal well area under first growth conditions such that the first horizontal well area has a first indium composition ratio in the first direction; and
forming a second horizontal well area under second growth conditions such that the second horizontal well area has a second indium composition ratio in the first direction, and
the first growth conditions are distinct from the second growth conditions in at least one of a growth temperature, an indium (In) injection rate, a gallium (Ga) injection rate, and a source gas injection rate, and
wherein the forming of the first well layer comprises including a temperature increase section ranging from a first temperature to a second temperature.

11. The method according to claim 10, wherein
the forming of the first horizontal well area comprises forming the first horizontal well area at the first temperature, and
the forming of the second horizontal well area comprises forming the second horizontal well area on the first horizontal well area at a third temperature between the first temperature and the second temperature.

12. The method according to claim 11, wherein the first barrier layer and the second barrier layer are formed at a fourth temperature higher than the second temperature.

13. The method according to any one of claims 10 to 12, wherein the source gas includes hydrogen gas.

14. The method according to any one of claims 10 to 13, wherein the forming of the first well layer further comprises forming a height compensation layer provided in an area including a relatively low indium composition ratio between the first horizontal well area and the second horizontal well area, and
wherein a thickness of the first horizontal well area is identical to a thickness of the second horizontal well area.

15. The method according to any one of claims 10 to 14, wherein, in the third direction, a first indium cluster including a first indium density and a second indium cluster including a second indium density different from the first indium density are formed in at least one area of the first horizontal well area and the second horizontal well area.
